# EUROPEAN PATENT SPECIFICATION

(11) **EP 0 982 851 B1**
(45) Date of publication and mention of the grant of the patent: **06.10.2004**
(21) Application number: 99306709.9
(22) Date of filing: 24.08.1999
(51) Int. Cl.: H03F 1/32

(54) **A linear amplifier arrangement**
Lineare Verstärkeranordnung
Dispositif d'amplificateur linéaire

(30) Priority: 27.08.1998 US 140934
(43) Date of publication of application: 01.03.2000
(73) Proprietor: Nortel Networks Limited, St. Laurent, Quebec H4S 2A9 (CA)
(72) Inventor: McNicol, John Duncan, Vaucresson 92420 (FR); Wessel, David Neal, Woodlawn, Ontario, K0A 3MO (CA)
(74) Representative: Anderson, Angela

(56) References cited:
- EP-A- 0 658 975
- US-A- 4 276 514
- US-A- 4 554 514
- US-A- 5 675 288
- US-A- 5 742 201

## Description

### FIELD OF THE INVENTION

This invention relates to high power linear amplifiers and in particular relates to the same for communication systems.

### BACKGROUND OF THE INVENTION

Linear amplifiers as used in communication systems exhibit a linear characteristic where the amplifiers output power increases relative to an input power. After a certain input level, known as a gain saturation point, the amplifier then exhibits non-linear characteristics; the output power increases relatively little with respect to power input. This non-linear region is also known as the saturation region or the gain compression region.

In systems such as Code Division Multiple Access (CDMA) modulation schemes, a plurality of signals are transmitted in a communication system and are amplified simultaneously. When a plurality of signals are applied to a linear amplifier, its non-linear characteristics will tend to produce interaction between the signals being amplified and the amplifier output will contain intermodulation products. Such intermodulation products reduce signal quality by allowing cross-talk to occur and such spillage often falls outside a particular licensed spectrum and must be controlled. Such intermodulation distortion can be reduced by negative feedback of the distortion components, pre-distortion of the signal to be amplified to cancel the amplifier generated distortion, or by separating the distortion components with the amplifier output and feeding forward the distortion component to cancel the distortion of the amplifier output signal. Feed forward is more complicated in that it requires the modification of the separated distortion component in amplitude and phase to match the gain and phase shift of the amplifier on a continuous basis.

WO97/24798 (Qualcomm) provides an out-of-band compensation system for a non-linear device. A signal source provided in the system provides an out-of-band signal, which out-of-band signal combines with a second signal derived from a non-constant envelope signal. The combined signal combines with the nonconstant envelope signal which is input to a non-linear power amplifier. No feedback is employed; the power of the combined signal is maintained at a nominal operating point.

US-A-4885551 (American Telephone and Telegraph Company) provides a feed forward linear amplifier. An input signal is applied to first and second paths one of which has a distortion component. The signals of the first and second circuits are combined to form a signal representative of the distortion component of the first circuit path whereby distortion can be cancelled. This complicated circuit however can be both difficult and expensive to produce.

Also US 4 554 514 discloses a power amplifier with controlled predistortion in order to increase the linearity.

### OBJECT OF THE INVENTION

The present invention seeks to provide an improved linear power amplifier arrangement. More particularly the present invention seeks to provide a linear power amplifier arrangement capable of amplifying and combining a number of frequency carriers or bearers.

### SUMMARY OF THE INVENTION

In accordance with a first aspect of the invention, there is provided a linear power amplifier arrangement comprising an input line, a power amplifier, an output line, an input tap, an output tap, an amplitude control element, a phase control element and, connected between said input line and said output line, a circuit comprising a delay element, a first signal splitter device, a second signal splitter device, a phase control block and an amplitude control block, and wherein in use: the input tap obtains a portion of the input signal, which portion is delayed by the delay element and is split by the first signal splitter device into phase and amplitude components, said phase and amplitude components being respectively fed to the phase control block and the amplitude control block; the output tap obtains a portion of the output signal from the high power amplifier which signal is split by the second splitter device into phase and amplitude components, said phase and amplitude components being respectively fed to the phase control block and the amplitude control block; whereby: the delayed input signal amplitude component is combined with the output signal amplitude component by the amplitude control block to produce an amplitude correction signal which is combined with the input signal, prior to it being amplified by the power amplifier, by the phase control element; and the delayed input signal phase component is combined with the output signal phase component by the phase control block to produce a phase correction signal which is combined with the output of the amplitude control element, prior to being amplified by the power amplifier, by the phase control element.

The phase control block can comprise a phase comparator, an amplifier and a divider; wherein the phase comparator is arranged to receive the delayed input signal phase component, Aexp(iα), and the output signal phase component, Bexp(iβ), as inputs and is arranged to provide two output signals ABsinϑ and ABcosϑ(where ϑ = α - β); wherein the amplifier is arranged to receive the signal ABsinϑ from the phase comparator and to output a signal to the divider, and; wherein the divider is arranged to receive the output signal of the amplifier and a control signal corresponding to signal ABcosϑ from the phase comparator and to provide a phase errorcorrection signal, tanϑ, to be combined with the output of the amplitude control element by the phase control element.

The amplitude control block can comprise an amplitude comparator block an operational-amplifier running in differential mode and a divider; wherein the amplitude comparator block comprises two envelope detectors arranged, respectively, to receive the delayed input signal amplitude component from the first signal splitter device and the output signal amplitude component from the second signal splitter device, which comparator block provides an amplitude dependent error correction signal; wherein the operational amplifier is arranged to receive signals from the amplitude comparator block at its positive and negative inputs output from the envelope detectors, which amplifier outputs a signal to the divider, and; wherein the divider receives a control voltage signal derived from an input signal of one of said envelope detectors, whereby the divider is arranged to provide an amplitude error correction signal to be combined with the input signal by the amplitude control elements.

In accordance with a second aspect of the invention, there is provided a method of operating a linear power amplifier arrangement comprising an input line, a power amplifier, an output line, an input tap, an output tap, an amplitude control element, a phase control element and, connected between said input line and said output line a circuit comprising a delay element, a first signal splitter device, a second signal splitter device, a phase control block and an amplitude control block, the method comprising the steps of: obtaining a portion of the input signal by means of the input tap, delaying said portion is by the delay element and splitting said input signal portion into phase and amplitude components; obtaining a portion of the output signal by means of the output tap to obtain a portion of the output signal from the high power amplifier and splitting said output signal portion into phase and amplitude components; combining the delayed input signal amplitude component with the output signal amplitude component by means of the amplitude control block to produce an amplitude correction signal and combining this with the input signal, prior to the input signal being amplified by the power amplifier, by the amplitude control element; combining the delayed input signal phase component with the output signal phase component by means of the phase control block to produce a phase correction signal and combining this with the output of the amplitude control element, prior to it being amplified by the power amplifier by the phase control element; whereby, in operation, the amplifier has a linear output signal.

### BRIEF DESCRIPTION OF THE DRAWINGS

In order that the present invention can be more fully understood and to show how the same may be carried into effect, reference shall now be made, by way of example only, to the figures as shown in the accompanying drawing sheets wherein:
Figure 1 is a graph depicting a typical amplifier non-linearity;
Figure 2 shows a first known amplifier arrangement;
Figure 3 shows a second known amplifier arrangement;
Figure 4 shows a prior art out of band compensation device;
Figure 5 shows a first embodiment of the invention;
Figure 6 shows in detail the phase control block of the embodiment shown in Figure 5;
Figure 7 shows in detail the amplitude control block of the embodiment shown in Figure 5, and;
Figures 8 and 9 show, respectively, non-linearized and linearized spectral emission graphs.

### DETAILED DESCRIPTION OF THE PREFERRED EMBODIMENTS

There will now be described by way of example the best mode contemplated by the inventors for carrying out the invention. In the following description, numerous specific details are set out in order to provide a complete understanding of the present invention. It will be apparent, however, to those skilled in the art that the present invention may be put into practice with variations of the specific.

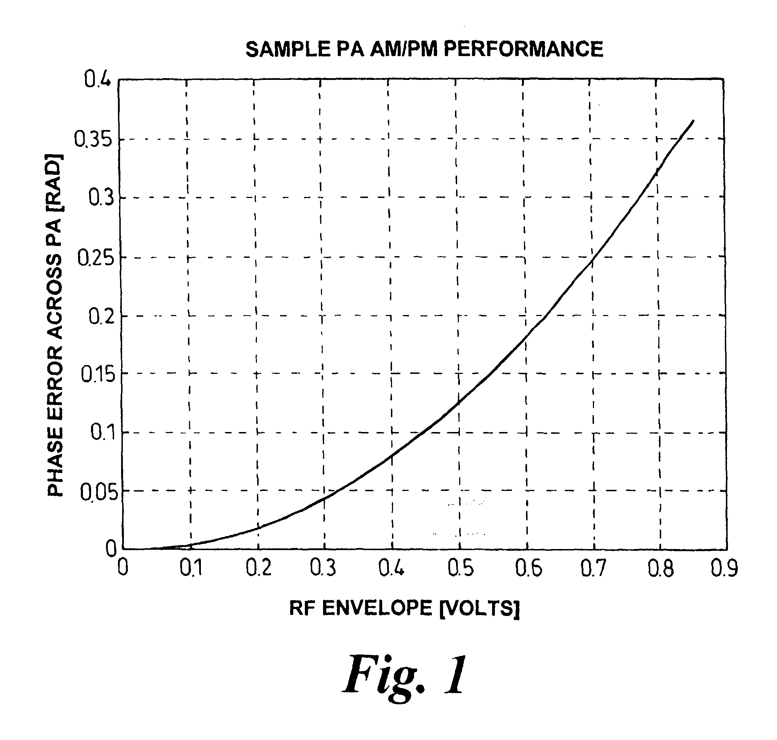

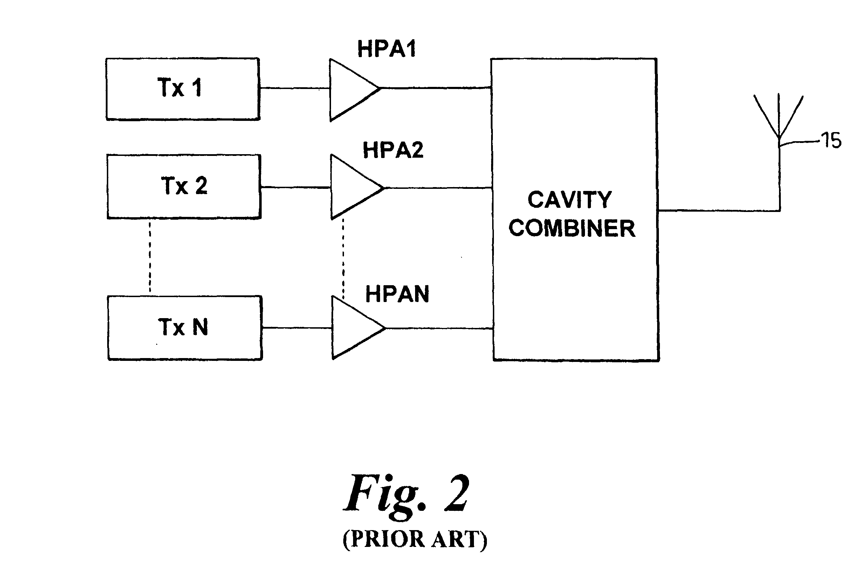

Figure 1 shows for a typical amplifier a plot of phase rotation versus envelope voltage, which could be provided by, for example, an amplifier as shown in Figure 2. The effective phase length of the amplifier varies with respect to the RF envelope voltage. Figure 2 shows a conventional cavity combiner transmitter system. A plurality of separate transmitters TX1, TX2....TXN each generate a signal which occupies a particular radio frequency band which is then amplified by respective high power amplifier HPA1, HPA2, .....HPAN. The set of N such amplified signals are combined by a cavity combiner 10 for feeding to an antenna 15.

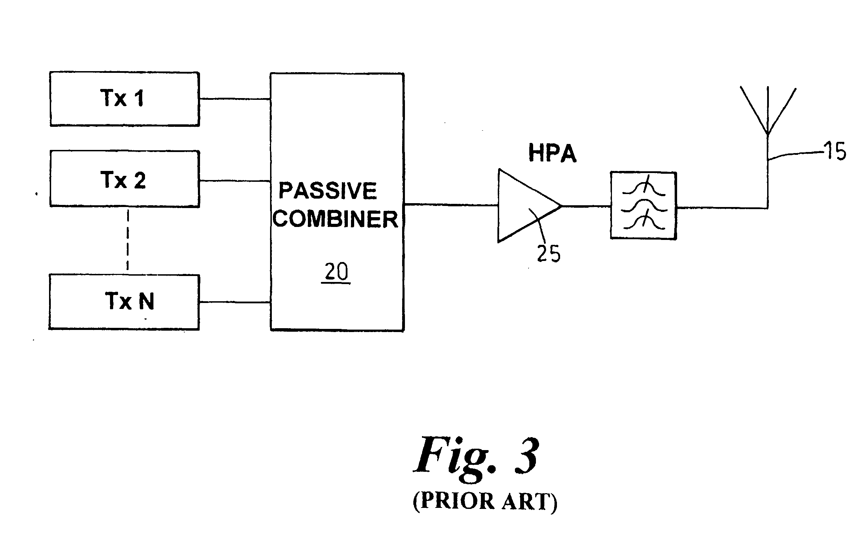

Figure 3 shows a further known method of achieving multiple radio frequency bearer amplification. A plurality of transmitters TX1, TX2,..... TXN each generate a signal which occupies a particular radio frequency band. The set of end such signals are combined by a passive combiner 20, amplified by high power amplifier HPA25 and fed to an antenna 15. HPA25 requires a linear amplitude/phase characteristic over a wide bandwidth. An advantage of this arrangement is that a single amplifier 25 is used, compared with a set of N amplifiers (HPA1, HPA2,....HPAN) used in the arrangement Figure 2. Accordingly it can be more cost effective to use this second arrangement.

Some known high power amplifier sub-systems employ control elements fed by a control signal derived by a phase comparator. The phase comparator compares the phase of an input signal entering the HPA sub-system with the phase of a signal tapped from an output of the HPA. The performance of a linear amplifier tends to be limited by the performance of the phase comparator and a delay through the amplifier. This type of system has been used with limited success.

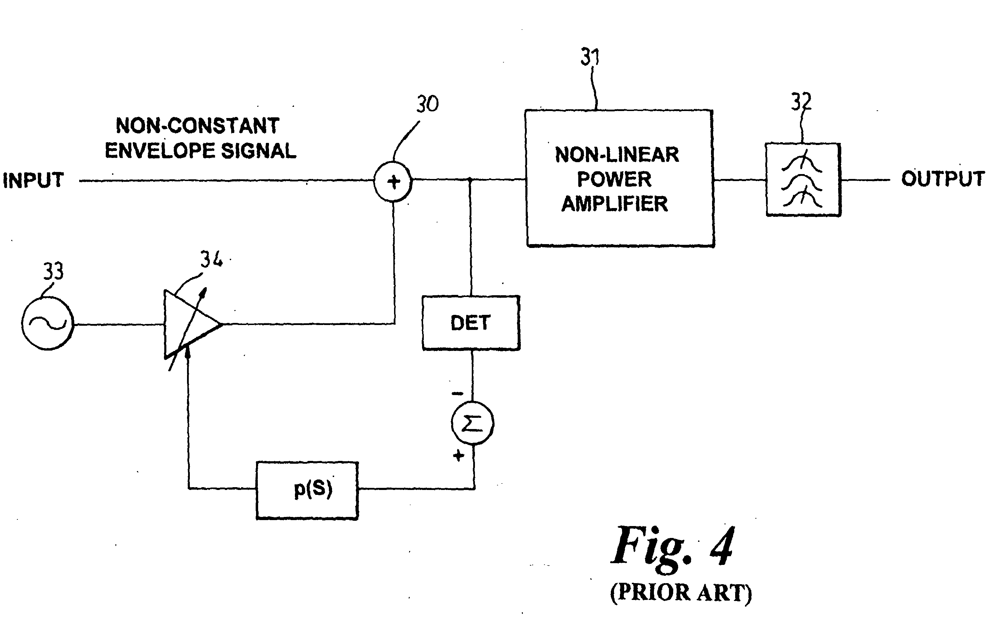

Figure 4 shows an example of an amplifier arrangement as proposed by Qualcomm in WO 97/24798. A non-constant envelope input signal is fed to a summer 30 prior to being input to a non-linear power amplifier 31. Output O/P signals are filtered by a band-pass filter 32 . The system adds an out of band signal, provided by oscillator 33, to the input signal to produce a combined signal which has a power that is substantially equal to a nominal operating point for the non-linear amplifier 31. It is preferred that the instantaneous power is variable by means of an automatic gain amplifier 34, which receives a control signal p(s)from a signal summed from a sample of the summed input signal

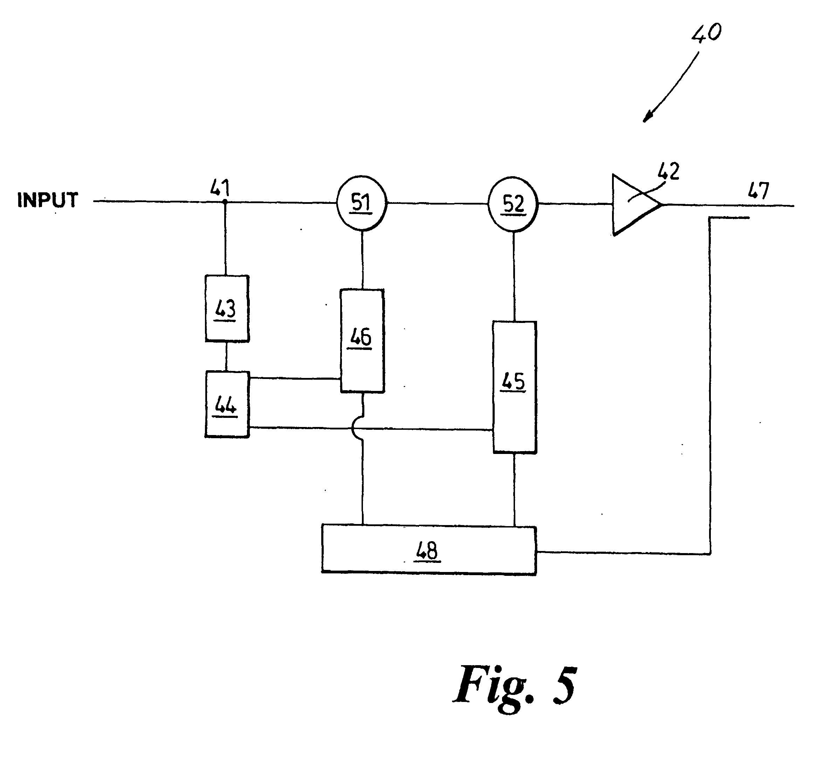

Referring now to Figure 5, there is shown an amplifier sub-system made in accordance with the invention. The amplifier sub-system 40 comprises an input line I/P which feeds a high power amplifier 42. A feedback arrangement receives a feedback signal from output tap 47. A signal tapped from the input line at input tap 41 feeds a delay element 43 which feeds a signal splitter device 44. Signal splitter device 44 splits the signal into phase components and amplitude components which are fed into respective phase and amplitude control blocks, 45, 46. Device 48 represents a phase and amplitude splitter for the feedback signals received from the output tap 47 and these signals are also fed into the respective phase and amplitude control blocks, 45, 46. The phase and amplitude blocks, 45, 46 provide respective phase and amplitude control signals to phase and amplitude control elements 52 and 51 on the input line, prior to amplification by the high power amplifier 42.

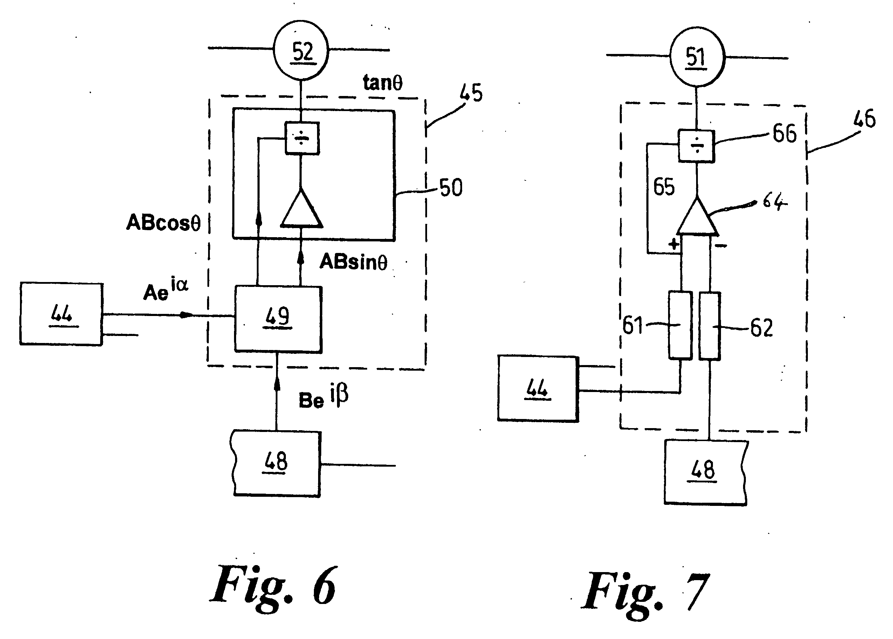

The phase control block (circuit) is shown in Figure 6 and comprises a phase comparator 49 and a phase control device 50 which, in turn, drives the phase control element 52. The phase comparator 49 receives a first input signal Aexp(iα), from the time delayed input signal splitter device 44, at a first input and receives a second input signal Bexp(iβ), the phase component of the feedback sampled output, from device 48 at a second input. The output signals from this phase comparator are ABcosϑ and ABsinϑ (where ϑ = α - β). The ABsinϑ signal is amplified and then fed to a divider of the phase control device 50 which receives an ABcosϑ control signal from the phase comparator. The output from the divider, tanϑ, is passed to phase control element 52.

Considering the amplitude control block (circuit), shown in Figure 7, there is provided an amplitude comparator block, which is equivalent to two envelope detectors, an envelope detector 61, 62 for each input, receiving amplitude signals, respectively, from the time delayed input signal splitter 44 and the feedback signal amplitude splitter device 48. The signals output from the envelope detectors 61, 62 are input to, respectively, the positive and negative inputs of an operational-amplifier 64 running in differential mode, which provides an amplitude dependent error signal. A control voltage signal coming via control voltage line 65, determined from the output of envelope detector 61 (the input envelope detector), is employed by divider 66 to divide the output of the operational amplifier. The divider 66 essentially comprises an attenuator, such as a variable attenuator, and the divided output of the operational amplifier drives the amplitude control element 51. Effectively, the input to the op-amp 64 comes round and acts as the control voltage and the signal modified by the divider 66 is passed to the control element 51.

This arrangement provides a clear separation of the respective phase and amplitude contributions whereby the separate phase and amplitude contributions respectively determine the phase and amplitude control elements, 51, 52 and there should not be any contamination of amplitude on the phase or phase on the amplitude using this technique. The amplifiers employed in the phase and amplitude blocks can be of amplifier class a/b: i.e. the high power amplifiers need not be particularly linear, and overall efficiencies can be of the order of 15-18%, for the 1800-1900 MHz range.

In a further embodiment, the signals fed to phase and amplitude control elements 52, 51 could be employed to drive a single vector control element.

Alternatively, the position of the phase and amplitude control elements 52, 51 may be interchanged.

In a still further embodiment, the signals employed to feed the phase and amplitude control elements 52, 51 could be employed to drive on adaptive predistortion architecture thus reducing or eliminating the bandwidth constraint due to the loop delay.

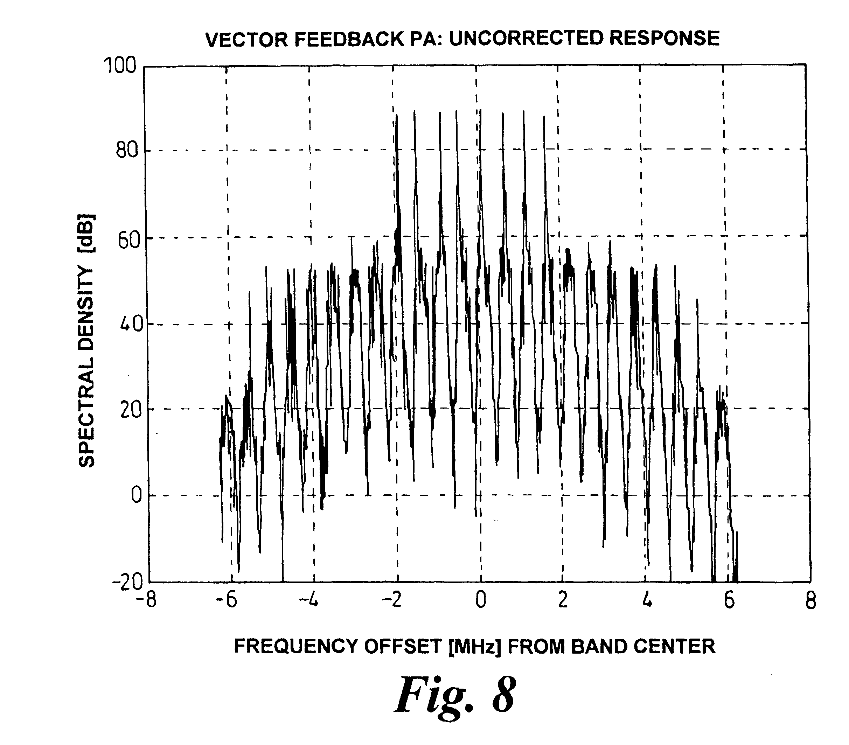

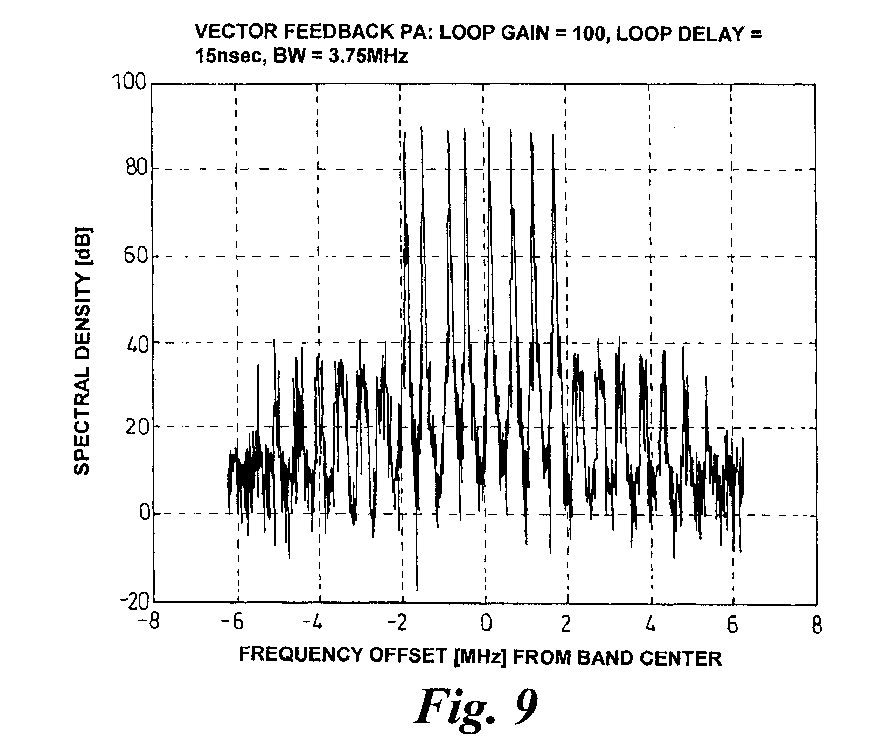

Figure 8 is a graph depicting the spectral emission of a non-linear amplifier having the phase rotation v amplitude voltage variance as depicted in Figure 1: the wanted frequency band is not sharply defined. In contrast, Figure 9 shows a plot of a simulation of an amplifier made in accordance with the present invention, providing improved spectral emissions. The loop delay is typically 15 nsec, with a gain of 100 Volts per Volt (40 dB).

In accordance with another embodiment it is possible to reduce the delay through the base band amplifier section and reduce requirements on the phase detector.

The base band attenuator (divider) is moved from the base band section to the RF section as a whole or only a portion thereof, i.e. to have two matched RF attenuators on each input port of the phase detector so that the phase detector input level is relatively constant over some input range (e.g. 15dB). The attenuators remain controlled by a single control derived from the RF envelope. This will reduce the base band gain requirement by twice the RF attenuation range (e.g. 30dB).

This modification would allow a lower delay through the baseband chain, make it easier to realise the baseband gain (without it oscillating), and reduce the accuracy requirements on the phase detector. It would be possible that one could use stepped RF attenuators, with attenuation setting updated at a suitably high rate (say every 10 nsec).

The requirement on the two attenuators is primarily that they are matched, i.e. it is the differential phase performance that matters. This differential performance is naturally much better than absolute performance and would respond well to the placing of applying both attenuators on the same substrate (if required). Further possible extensions are the same as RF attenuators to the gain loop, where the attenuator differential gain can be important; and using sampled signals in the feedback chains.

Previous designs for providing amplification have, for example, three amplifiers and a combiner. Benefits of the present invention are primarily of size and cost savings: board space and the total number of piece parts, amongst other characteristics and/or requirements are reduced relative to prior art multi-carrier power amplifiers using dual loop feed forward technology with typical efficiencies of around 4 and half percent when operating on IS95 type signals, irrespective of number of IS 95 bearers. Typically, the present invention will provide an amplifier that is half the cost yet twice the efficiency of prior art amplifiers.

## Claims

1. A linear power amplifier arrangement comprising an input line, a power amplifier (42), an output line, an input tap (41), an output tap (47), an amplitude control element (51), a phase control element (52) and, connected between said input line and said output line, a circuit comprising a delay element (43), a first signal splitter device (44), a second signal splitter device (48), a phase control block (45) and an amplitude control block (46), and
wherein in use:
the input tap obtains a portion of the input signal, which portion is delayed by the delay element (43) and is split by the first signal splitter device (44) into phase and amplitude components, said phase and amplitude components being respectively fed to the phase control block (45) and the amplitude control block (46);
the output tap (47) obtains a portion of the output signal from the high power amplifier (42) which signal is split by the second signal splitter device (48) into phase and amplitude components, said phase and amplitude components being respectively fed to the phase control block (45) and the amplitude control block (46);
whereby:
the delayed input signal amplitude component is combined with the output signal amplitude component by the amplitude control block (46) to produce an amplitude correction signal which is combined with the input signal, prior to it being amplified by the power amplifier (42), by the phase control element (51); and
the delayed input signal phase component is combined with the output signal phase component by the phase control block (45) to produce a phase correction signal which is combined with the output of the amplitude control element (51), prior to it being amplified by the power amplifier (42), by the phase control element (52).

2. A linear power amplifier arrangement according to claim 1 wherein the phase control block (45) comprises a phase comparator (49), an amplifier and a divider;
wherein the phase comparator (49) is arranged to receive the delayed input signal phase component, Aexp(iα), and the output signal phase component, Bexp(iβ), as inputs and is arranged to provide two output signals ABsinϑ and ABcosϑ (where ϑ = α - β);
wherein the amplifier is arranged to receive the signal ABsinϑ from the phase comparator (49) and to output a signal to the divider, and;
wherein the divider is arranged to receive the output signal of the amplifier and a control signal corresponding to signal ABcosϑ from the phase comparator (49) and to provide a phase error correction signal, tanϑ, to be combined with the output of the amplitude control element (51) by the phase control element (52).

3. A linearpower amplifier arrangement according to claim 1 or claim 2, wherein the amplitude control block (46) comprises an amplitude comparator block (61, 62) an operational-amplifier (64) running in differential mode and a divider (66);
wherein the amplitude comparator block comprises two envelope detectors (61, 62) arranged, respectively, to receive the delayed input signal amplitude component from the first signal splitter device (44) and the output signal amplitude component from the second signal splitter device (48), which comparator block provides an amplitude dependent error correction signal;
wherein the operational amplifer (64) is arranged to receive signals from the amplitude comparator block at its positive and negative inputs output from the envelope detectors (61, 62), which amplifier (64) outputs a signal to the divider (66), and;
wherein the divider (66) receives a control voltage signal derived from an input signal of one of said envelope detectors, whereby the divider (66) is arranged to provide an amplitude error correction signal to be combined with the input signal by the amplitude control elements (51).

4. A linear power amplifier arrangement according to claim 3, wherein the divider (66) comprises an attenuator.

5. A linear power amplifier arrangement according to claim 4, wherein the divider (66) comprises a variable attenuator.

6. A linear power amplifier arrangement as claimed in any preceding claim, wherein the amplifier control element (51) is placed after the phase control element (52) between the input line and power amplifier (42) such that the amplitude correction signal is combined with the output of the phase control element (52) by the amplitude control element (51).

7. A method of operating a linear power amplifier arrangement comprising an input line, a power amplifier (42), an output line, an input tap (41), an output tap (47), an amplitude control element (51 ), a phase control element (52) and, connected between said input line and said output line, a circuit comprising a delay element (43), a first signal splitter device (44), a second signal splitter device (48), a phase control block (45) and an amplitude control block (46), the method comprising the steps of:
obtaining a portion of the input signal by means of the input tap (41), delaying said portion by the delay element (43) and splitting said input signal portion into phase and amplitude components;
obtaining a portion of the output signal by means of the output tap (47) to obtain a portion of the output signal from the high power amplifier (42) and splitting said output signal portion into phase and amplitude components;
combining the delayed input signal amplitude component with the output signal amplitude component by means of the amplitude control block (46) to produce an amplitude correction signal and combining this with the input signal, prior to the input signal being amplified by the power amplifier (42), by the amplitude control element (51);
combining the delayed input signal phase component with the output signal phase component by means of the phase control block (45) to produce a phase correction signal and combining this with the output of the amplitude control element (51), prior to it being amplified by the power amplifier (42), by the phase control element (52);
whereby, in operation, the amplifier has a linear output signal.

8. A method as claimed in claim 7, wherein the amplifier control element (51) is placed after the phase control element (52) between the input line and power amplifier (42) such that the amplitude correction signal is combined with the output of the phase control element (52) by the amplitude control element (51 ).

## Patentansprüche

1. Lineare Leistungsverstärker-Anordnung mit einer Eingangsleitung, einem Leistungsverstärker (42), einer Ausgangsleitung, einer Eingangsanzapfung (41), einer Ausgangsanzapfung (47), einem Amplituden-Steuerelement (51), einem Phasen-Steuerelement (52) und einer zwischen der Eingangsleitung und der Ausgangsleitung eingeschalteten Schaltung, die ein Verzögerungselement (43), ein erstes Signalteiler-Bauteil (44), ein zweites Signalteiler-Bauteil (48), einen Phasen-Steuerblock (45) und einen Amplituden-Steuerblock (46) umfasst, und
wobei im Gebrauch:
die Eingangsanzapfung einen Teil des Eingangssignals gewinnt, wobei dieser Teil von dem Verzögerungselement (43) verzögert und von dem ersten Signalteiler-Bauteil (44) in Phasen- und Amplitudenkomponenten aufgeteilt wird, wobei die Phasen- und Amplitudenkomponenten jeweils dem Phasen-Steuerblock (45) bzw. dem Amplituden-Steuerblock (46) zugeführt werden;
die Ausgangsanzapfung (47) einen Teil des Ausgangssignals von dem Hochleistungsverstärker (42) gewinnt, wobei dieses Signal von dem zweiten Signalteiler-Bauteil (48) in Phasen- und Amplitudenkomponenten aufgeteilt wird, wobei die Phasen- und Amplitudenkomponenten jeweils dem Phasen-Steuerblock (45) bzw. dem Amplituden-Steuerblock (46) zugeführt werden;
wobei:
die verzögerte Eingangssignal-Amplitudenkomponente mit der Ausgangssignal-Amplitudenkomponente durch den Amplituden-Steuerblock (46) kombiniert wird, um ein Amplituden-Korrektursignal zu erzeugen, das mit dem Eingangssignal vor dessen Verstärkung in dem Leistungsverstärker (42) durch das Phasen-Steuerelement (51) kombiniert wird; und
die verzögerte Eingangssignal-Phasenkomponente mit der Ausgangssignal-Phasenkomponente durch den Phasen-Steuerblock (45) kombiniert wird, um ein Phasen-Korrektursignal zu erzeugen, das mit dem Ausgang des Amplituden-Steuerelementes (51) vor dessen Verstärkung in dem Leistungsverstärker (42) durch das Phasen-Steuerelement (52) kombiniert wird.

2. Lineare Leistungsverstärker-Anordnung nach Anspruch 1, bei der der Phasen-Steuerblock (45) einen Phasenvergleicher (49), einen Verstärker und einen Teiler umfasst; wobei der Phasenvergleicher (49) zum Empfang der verzögerten Eingangssignal-Phasenkomponente Aexp(iα) und der Ausgangssignal-Phasenkomponente Bexp(iβ) als Eingangssignale angeordnet ist und zur Lieferung von zwei Ausgangssignalen ABsinϑ und ABcosϑ angeordnet ist (worin ϑ = α - β ist);
wobei der Verstärker zum Empfang des Signals ABsinϑ von dem Phasenvergleicher (49) und zur Abgabe eines Ausgangssignals an den Teiler ausgebildet ist; und
wobei der Teiler zum Empfang des Ausgangssignals des Verstärkers und eines Steuersignals, das dem Signal ABcosϑ von dem Phasenvergleicher (49) entspricht, und zur Lieferung eines Phasenfehler-Korrektursignals tanϑ ausgebildet ist, das mit dem Ausgangssignal des Amplituden-Steuerelementes (51) durch das Phasen-Steuerelement (52) zu kombinieren ist.

3. Lineare Leistungsverstärker-Anordnung nach Anspruch 1 oder 2, bei der der Amplituden-Steuerblock (46) einen Amplituden-Vergleicherblock (61, 62), einen Operationsverstärker (64), der in der Differenzbetriebsart arbeitet, und einen Teiler (66) umfasst;
wobei der Amplituden-Vergleicherblock zwei Hüllkurvendetektoren (61, 62) umfasst, die jeweils zum Empfang der verzögerten Eingangssignal-Amplitudenkomponente von dem ersten Signalteiler-Bauteil (44) bzw. der Ausgangssignal-Amplitudenkomponente von dem zweiten Signalteiler-Bauteil (48) angeordnet sind, wobei dieser Vergleicherblock ein amplitudenabhängiges Fehlerkorrektursignal liefert;
wobei der Operationsverstärker (64) zum Empfang von Signalen von dem Amplituden-Vergleicherblock an seinen positiven und negativen Eingängen ausgebildet ist, die von den Hüllkurvendetektoren (61, 62) als Ausgang abgegeben werden, wobei der Verstärker (64) ein Signal an den Teiler (66) abgibt; und
wobei der Teiler (66) eine Steuerspannung empfängt, die von einem Eingangssignal eines der Hüllkurvendetektoren abgeleitet ist, wobei der Teiler (66) zur Lieferung eines Amplitudenfehler-Korrektursignals ausgebildet ist, das mit dem Eingangssignal durch das Amplituden-Steuerelement (51) zu kombinieren ist.

4. Lineare Leistungsverstärker-Anordnung nach Anspruch 3, bei dem der Teiler (66) ein Dämpfungsglied umfasst.

5. Lineare Leistungsverstärker-Anordnung nach Anspruch 4, bei der der Teiler (66) ein veränderbares Dämpfungsglied umfasst.

6. Lineare Leistungsverstärker-Anordnung nach einem der Ansprüche, bei der das Verstärkungs-Steuerelement (51) nach dem Phasen-Steuerelement (52) zwischen der Eingangsleitung und dem Leistungsverstärker (42) derart angeordnet ist, dass das Amplituden-Korrektursignal mit dem Ausgang des Phasen-Steuerelementes (52) in dem Amplituden-Steuerelement (51) kombiniert wird.

7. Verfahren zum Betrieb einer linearen Leistungsverstärker-Anordnung, die eine Eingangsleitung, einen Leistungsverstärker (42), eine Ausgangsleitung, eine Eingangsanzapfung (41), eine Ausgangsanzapfung (47), ein Amplituden-Steuerelement (51), ein Phasen-Steuerelement (52) und eine zwischen der Eingangsleitung und der Ausgangsleitung eingeschaltete Schaltung umfasst, die ein Verzögerungselement (43), ein erstes Signalteiler-Bauteil (44), ein zweites Signalteiler-Bauteil (48), einen Phasen-Steuerblock (45) und einen Amplituden-Steuerblock (46) umfasst, wobei das Verfahren die folgenden Schritte umfasst:
Gewinnen eines Teils des Eingangssignals mit Hilfe der Eingangsanzapfung (41); Verzögern des Teils durch das Verzögerungselement (43) und Aufteilen des Eingangssignal-Teils in Phasen- und Amplitudenkomponenten;
Gewinnen eines Teils des Ausgangssignals mit Hilfe der Ausgangsanzapfung (47) zum Gewinnen eines Teils des Ausgangssignals von dem Hochleistungsverstärker (42) und Aufteilen des Ausgangssignal-Teils in Phasen- und Amplitudenkomponenten;
Kombinieren der verzögerten Eingangssignal-Amplitudenkomponente mit der Ausgangssignal-Amplitudenkomponente mit Hilfe des Amplituden-Steuerblockes (46) zur Erzeugung eines Amplituden-Korrektursignals und Kombinieren dieses Signals mit dem Eingangssignal vor der Verstärkung des Eingangssignals in dem Leistungsverstärker (42) durch das Amplituden-Steuerelement (51);
Kombinieren der verzögerten Eingangssignal-Phasenkomponente mit der Ausgangssignal-Phasenkomponente mit Hilfe des Phasen-Steuerblockes (45) zur Erzeugung eines Phasen-Korrektursignals und Kombinieren dieses Signals mit dem Ausgang des Amplituden-Steuerelementes (51) vor dessen Verstärkung in dem Leistungsverstärker (42) durch das Phasen-Steuerelement (52);
wodurch im Betrieb der Verstärker ein lineares Ausgangssignal aufweist.

8. Verfahren nach Anspruch 7, bei dem das Verstärker-Steuerelement (51) nach dem Phasen-Steuerelement (52) zwischen der Eingangsleitung und dem Leistungsverstärker (42) derart angeordnet ist, dass das Amplituden-Korrektursignal mit dem Ausgang des Phasen-Steuerelementes (52) durch das Amplituden-Steuerelement (51) kombiniert wird.

## Revendications

1. Agencement d'amplificateur de puissance linéaire comprenant une ligne d'entrée, un amplificateur de puissance (42), une ligne de sortie, une prise d'entrée (41), une prise de sortie (47), un élément de commande d'amplitude (51), un élément de commande de phase (52) et, connecté entre ladite ligne d'entrée et ladite ligne de sortie, un circuit comprenant un élément à retard (43), un premier dispositif de séparation de signal (44), un deuxième dispositif de séparation de signal (48), un bloc de commande de phase (45) et un bloc de commande d'amplitude (46), et
dans lequel, en fonctionnement :
la prise d'entrée obtient une partie du signal d'entrée, laquelle partie est retardée par l'élément à retard (43) et est séparée par le premier dispositif de séparation de signal (44) en composantes de phase et d'amplitude, lesdites composantes de phase et d'amplitude étant respectivement fournies au bloc de commande de phase (45) et au bloc de commande d'amplitude (46) ;
la prise de sortie (47) obtient une partie du signal de sortie de l'amplificateur haute puissance (42), lequel signal est séparé par le deuxième dispositif de séparation de signal (48) en composantes de phase et d'amplitude, lesdites composantes de phase et d'amplitude étant respectivement fournies au bloc de commande de phase (45) et au bloc de commande d'amplitude (46) ;
moyennant quoi :
la composante d'amplitude de signal d'entrée retardée est combinée avec la composante d'amplitude de signal de sortie par le bloc de commande d'amplitude (46) afin de produire un signal de correction d'amplitude qui est combiné avec le signal d'entrée, avant d'être amplifié par l'amplificateur de puissance (42), par l'élément de commande d'amplitude (51) ; et
la composante de phase de signal d'entrée retardée est combinée avec la composante de phase de signal de sortie par le bloc de commande de phase (45) afin de produire un signal de correction de phase qui est combiné avec la sortie de l'élément de commande d'amplitude (51), avant d'être amplifié par l'amplificateur de puissance (42), par l'élément de commande de phase (52).

2. Agencement d'amplificateur de puissance linéaire selon la revendication 1, dans lequel le bloc de commande de phase (45) comprend un comparateur de phase (49), un amplificateur et un diviseur ;
dans lequel le comparateur de phase (49) est agencé pour recevoir la composante de phase de signal d'entrée retardée, Aexp(iα), et la composante de phase de signal de sortie, Bexp(iβ), en tant qu'entrées et est agencé pour fournir deux signaux de sortie ABsinϑ et ABcosϑ, où ϑ = α - β ;
dans lequel l'amplificateur est agencé pour recevoir le signal ABsinϑ du comparateur de phase (49) et pour délivrer un signal au diviseur ; et
dans lequel le diviseur est agencé pour recevoir le signal de sortie de l'amplificateur et un signal de commande correspondant au signal ABcosϑ du comparateur de phase (49) et pour fournir un signal de correction d'erreur de phase, tgϑ, devant être combiné avec la sortie de l'élément de commande d'amplitude (51) par l'élément de commande de phase (52).

3. Agencement d'amplificateur de puissance linéaire selon la revendication 1 ou la revendication 2, dans lequel le bloc de commande d'amplitude (46) comprend un bloc de comparateur d'amplitude (61, 62), un amplificateur opérationnel (64) fonctionnant dans un mode différentiel et un diviseur (66) ;
dans lequel le bloc de comparateur d'amplitude comprend deux détecteurs d'enveloppe (61, 62) agencés, respectivement, pour recevoir la composante d'amplitude de signal d'entrée retardée du premier dispositif séparateur de signal (44) et la composante d'amplitude de signal de sortie du deuxième dispositif séparateur de signal (48), lequel bloc de comparateur fournit un signal de correction d'erreur dépendant de l'amplitude ;
dans lequel l'amplificateur opérationnel (64) est agencé pour recevoir des signaux du bloc de comparateur d'amplitude au niveau de ses entrées positive et négative délivrés par les détecteurs d'enveloppe (61, 62), lequel amplificateur (64) délivre un signal au diviseur (66) ; et
dans lequel le diviseur (66) reçoit un signal de tension de commande déduit d'un signal d'entrée d'un desdits détecteurs d'enveloppe, moyennant quoi le diviseur (66) est agencé pour fournir un signal de correction d'erreur d'amplitude devant être combiné avec le signal d'entrée par l'élément de commande d'amplitude (51).

4. Agencement d'amplificateur de puissance linéaire selon la revendication 3, dans lequel le diviseur (66) comprend un atténuateur.

5. Agencement d'amplificateur de puissance linéaire selon la revendication 4, dans lequel le diviseur (66) comprend un atténuateur variable.

6. Agencement d'amplificateur de puissance linéaire selon l'une quelconque des revendications précédentes, dans lequel l'élément de commande d'amplitude (51) est placé après l'élément de commande de phase (52) entre la ligne d'entrée et l'amplificateur de puissance (42) de sorte que le signal de correction d'amplitude soit combiné avec la sortie de l'élément de commande de phase (52) par l'élément de commande d'amplitude (51).

7. Procédé de mise en oeuvre d'un agencement d'amplificateur de puissance linéaire comprenant une ligne d'entrée, un amplificateur de puissance (42), une ligne de sortie, une prise d'entrée (41), une prise de sortie (47), un élément de commande d'amplitude (51), un élément de commande de phase (52) et, connecté entre ladite ligne d'entrée et ladite ligne de sortie, un circuit comprenant un élément à retard (43), un premier dispositif de séparation de signal (44), un deuxième dispositif de séparation de signal (48), un bloc de commande de phase (45) et un bloc de commande d'amplitude (46), le procédé comprenant les étapes consistant à :
obtenir une partie du signal d'entrée au moyen de la prise d'entrée (41), retarder ladite partie par l'élément à retard (43) et séparer ladite partie de signal d'entrée en composantes de phase et d'amplitude ;
obtenir une partie du signal de sortie au moyen de la prise de sortie (47) afin d'obtenir une partie du signal de sortie de l'amplificateur haute puissance (42) et séparer ladite partie de signal de sortie en composantes de phase et d'amplitude ;
combiner la composante d'amplitude de signal d'entrée retardée avec la composante d'amplitude de signal de sortie au moyen du bloc de commande d'amplitude (46) afin de produire un signal de correction d'amplitude et de le combiner avec le signal d'entrée, avant que le signal d'entrée ne soit amplifié par l'amplificateur de puissance (42), par l'élément de commande d'amplitude (51) ;
combiner la composante de phase de signal d'entrée retardée avec la composante de phase de signal de sortie au moyen du bloc de commande de phase (45) afin de produire un signal de correction de phase et combiner celui-ci avec la sortie de l'élément de commande d'amplitude (51), avant qu'il soit amplifié par l'amplificateur de puissance (42), par l'élément de commande de phase (52) ;
moyennant quoi, en fonctionnement, l'amplificateur a un signal de sortie linéaire.

8. Procédé selon la revendication 7, dans lequel l'élément de commande d'amplitude (51) est placé après l'élément de commande de phase (52) entre la ligne d'entrée et l'amplificateur de puissance (42) de sorte que le signal de correction d'amplitude soit combiné avec la sortie de l'élément de commande de phase (52) par l'élément de commande d'amplitude (51).
